# EUROPÄISCHE PATENTANMELDUNG

(11) **EP 1 302 778 A2**
(43) Veröffentlichungstag der Anmeldung: **16.04.2003**
(21) Anmeldenummer: 02020986.2
(22) Anmeldetag: 20.09.2002
(51) Int. Cl.: G01R 33/09

(54) **Sensorvorrichtung zur Messung von Magnetfeldern und Herstellungsverfahren derselben**

(30) Priorität: 09.10.2001 DE 10149776
(71) Anmelder: ROBERT BOSCH GMBH, 70442 Stuttgart (DE)
(72) Erfinder: Ernst, Stephan, 73760 Ostfildern (DE); Qu, Ning, 72770 Reutlingen (DE)

(57) **Zusammenfassung**

Die vorliegende Erfindung schafft eine Sensorvorrichtung und ein Herstellungsverfahren einer Sensorvorrichtung zur Messung von Magnetfeldern, insbesondere über einen breiten Messbereich, mit: einem Halbleiterchip 1; mindestens einem Magnetotransistorelement 2; und mit mindestens einem magnetoresistiven Sensorelement 3; wobei das Magnetotransistorelement 2 sowie das magnetoresistive Sensorelement 3 zur Messung von Magnetfeldern parallel zur Oberfläche des Halbleiterchips 1 monolithisch in dem Halbleiterchip 1 integriert sind.

## Beschreibung

### STAND DER TECHNIK

Die vorliegende Erfindung betrifft eine Sensorvorrichtung zur Messung von Magnetfeldern, insbesondere über einen breiten Messbereich.

Obwohl auf mehrere Anwendungsgebiete anwendbar, werden die vorliegende Erfindung sowie die ihr zugrunde liegende Problematik in Bezug auf den Kraftfahrzeugbereich erläutert.

Magnetfeldsensoren werden in einem Kraftfahrzeug beispielsweise als ABS-Radsensoren, Sensoren zur Erfassung der Motor- und Getriebedrehzahl bzw. des Drehmomentes, Sensoren für Lenkwinkel, für die Stellung von Drosselklappen, Pedalen, Nocken- und Kurbelwellen oder dergleichen verwendet. Über eine Messung der entsprechenden Magnetfelder bzw. der fließenden Ströme können Rückschlüsse auf verschiedene Kraftfahrzeugkomponenten und deren Aktivitäten gezogen werden.

Allgemein können im Kraftfahrzeugbereich die zu messenden Magnetfelder bzw. zu messende Ströme einen sehr breiten Messbereich, beispielsweise über mehr als fünf Größenordnungen, einnehmen.

Für eine einfache quantitative Messung der relevanten Magnetfelder werden sogenannte lineare Magnetfeldsensoren benutzt, welche nicht nur die Richtungen der Magnetfelder messen, sondern auch in einem definierten Messbereich Signale liefern, die mit den zu messenden Größen linear korrelieren. Einer besonderen Beliebtheit erfreut sich zumindest als Drehzahlgeber der Hall-Sensor aufgrund seines relativ günstigen Preises. Allerdings deckt der Hall-Sensor sowie die anderen einzelnen Typen von linearen Magnetfeldsensoren lediglich einen relativ eng begrenzten Messbereich ab.

Um jedoch einen möglichst breiten Messbereich abdecken zu können, müssten mehrere lineare Magnetfeldsensoren verschiedener Typen mit unterschiedlichen Messbereichen und eigener Elektronik einzeln nebeneinander eingesetzt werden.

Hierbei muss allerdings ein hoher Platzbedarf und die hohen Kosten als nachteilig angesehen werden.

### VORTEILE DER ERFINDUNG

Die erfindungsgemäße Sensorvorrichtung mit den Merkmalen des Anspruchs 1 sowie das entsprechende Verfahren zur Herstellung derselben gemäß Anspruch 12 weisen gegenüber den bekannten Lösungsansätzen den Vorteil auf, dass eine platzsparende und kostengünstige Sensorvorrichtung zur Messung von Magnetfeldern geschaffen wird, die zudem einen breiten Messbereich aufweist.

Die der vorliegenden Erfindung zugrunde liegende Idee besteht darin, dass die Sensorvorrichtung einen Halbleiterchip, mindestens ein Magneto-Transistorelement und mindestens ein magnetoresistives Sensorelement aufweist, wobei das Magneto-Transistorelement sowie das magnetoresistive Sensorelement zur Messung von Magnetfeldern parallel zur Oberfläche des Halbleiterchips monolithisch in dem Halbleiter-Chip integriert werden.

Neben der erreichten Volumenreduzierung und der Kosteneinsparung kann somit ebenfalls der Montageaufwand reduziert werden.

In den Unteransprüchen finden sich vorteilhafte Weiterbildungen und Verbesserungen der in Anspruch 1 angegebenen Sensorvorrichtung bzw. des in Anspruch 12 angegebenen Herstellungsverfahrens derselben.

Gemäß einer bevorzugten Weiterbildung ist der Halbleiterchip aus Silizium gebildet. Allerdings sind andere entsprechend geeignete Halbleitermaterialien vorstellbar.

Gemäß einer weiteren bevorzugten Weiterbildung ist das magnetoresistive Sensorelement als AMR (Anisotropic Magneto Resistance)-Element gebildet. Hierbei wird ausgenutzt, dass der Widerstand in einem stromdurchflossenen Streifen aus weichmagnetischem Material, beispielsweise NiFe (Permalloy) direkt vom Winkel zwischen Strom und Magnetisierungsrichtung abhängt.

Gemäß einer weiteren bevorzugten Weiterbildung ist das magnetoresistive Sensorelement als GMR(Giant Magnetic Resistance)-Element gebildet. Bei diesen tritt ein magnetoresistiver Effekt mit vergleichsweise "gigantischer" Effektgröße in sehr dünnen Schichtsystemen auf, welche prinzipiell aus zwei magnetischen Schichten, zum Beispiel CO (Kobalt), und einer unmagnetischen Zwischenschicht, zum Beispiel Cu (Kupfer), bzw. in daraus abgeleiteten Mehrschichtsystemen auftritt. Der elektrische Widerstand längs der Schichtstruktur hängt in diesem Falle direkt von der relativen Orientierung der magnetischen Momente der Schichten ab.

Gemäß einer weiteren bevorzugten Weiterbildung sind das Magnetotransistorelement und das magnetoresistive Sensorelement bezüglich der Oberfläche des Halbleiterchips nebeneinander in dem Halbleiterchip monolithisch integriert.

Dies hat den Vorteil einer guten Wärmeabführung an der Oberfläche des Halbleiterchips der beiden Sensorelemente.

Gemäß einer weiteren bevorzugten Weiterbildung ist das Magnetotransistorelement bezüglich der Oberfläche des Halbleiterchips unter dem magnetoresistiven Sensorelement in dem Halbleiterchip monolithisch integriert. Ein derartiger Aufbau weist eine äußerst platzsparende und kompakte Struktur auf.

Gemäß einer weiteren bevorzugten Weiterbildung ist eine Auswerteschaltung zum Auswerten der Messsignale des Magnetotransistorelementes und des magnetoresistiven Sensorelementes in einem Halbleiterchip monolithisch integriert. Dies trägt ferner zu einer kompakten Struktur bei.

Gemäß einer weiteren bevorzugten Weiterbildung ist das Magnetotransistorelement als lateraler Magnetotransistor, ein anderes Sensorelelement, das ein Magnetfeld parallel zur Si-Oberfläche messen kann, oder dergleichen ausgebildet.

Gemäß einer weiteren bevorzugten Weiterbildung sind mehrere Schaltungsblöcke mit unterschiedlichen Eigenschaften, beispielsweise unterschiedlichen Verstärkungsfaktoren, zum Verarbeiten und Auswerten der Messsignale mit den entsprechenden Sensoren verbindbar, wobei für eine bestimmte Messung die entsprechenden Schaltungsblöcke und Sensoren mittels einer Software entsprechend ansteuerbar sind.

Gemäß einer weiteren bevorzugten Weiterbildung ist ein Schaltungsblock mit steuerbaren Eigenschaften, beispielsweise einem steuerbaren Verstärkungsfaktor, mit den entsprechenden Sensoren verbindbar, wobei für eine bestimmte Messung der Schaltungsblock mittels einer Software entsprechend ansteuerbar bzw. schaltbar ist.

Gemäß einer weiteren bevorzugten Weiterbildung weist das Magnetoresistorelement eine pnp- oder eine npn-Struktur auf.

Beim Herstellungsverfahren der Sensorvorrichtung wird vorzugsweise zunächst das Magnetotransistorelement mittels eines Halbleiterprozesses in dem Halbleitersubstrat gebildet, eine Isolationsschicht auf der Halbleitersubstrat-Oberfläche und schließlich monolithisch das magnetoresistive Sensorelement mittels eines Postprozesses in dem Halbleitersubstrat gebildet.

Gemäß einem weiteren bevorzugten Ausführungsbeispiel wird darauf folgend eine Passivierungsschicht auf der Oberfläche der Isolationsschicht und vorzugsweise eine Metallisierungsschicht auf der Unterseite des Halbleitersubstrates gebildet.

### ZEICHNUNGEN

Ausführungsbeispiele der Erfindung sind in den Zeichnungen dargestellt und in der nachfolgenden Beschreibung näher erläutert.

In den Figuren zeigen:
- Figur 1: eine schematische Ansicht eines Aufbaus zur Strom-bzw. Magnetfeldmessung mit einem Magnetfeldsensor;
- Figur 2a: einen Prozessschritt zur Herstellung eines Magnetotransistorelementes gemäß einem Ausführungsbeispiel der vorliegenden Erfindung;
- Figur 2b: einen Postprozess zur Herstellung eines magnetoresistiven Sensorelementes gemäß einem Ausführungsbeispiel der vorliegenden Erfindung;
- Figur 3a: einen Prozessschritt zur Herstellung eines Magnetotransistorelementes gemäß einem zweiten Ausführungsbeispiel der vorliegenden Erfindung; und
- Figur 3b: einen Postprozessschritt zur Herstellung eines magnetoresistiven Sensorelementes gemäß dem zweiten Ausführungsbeispiel der vorliegenden Erfindung.

### BESCHREIBUNG DER AUSFÜHRUNGSBEISPIELE

In den Figuren bezeichnen gleiche Bezugszeichen gleiche oder funktionsgleiche Komponenten.

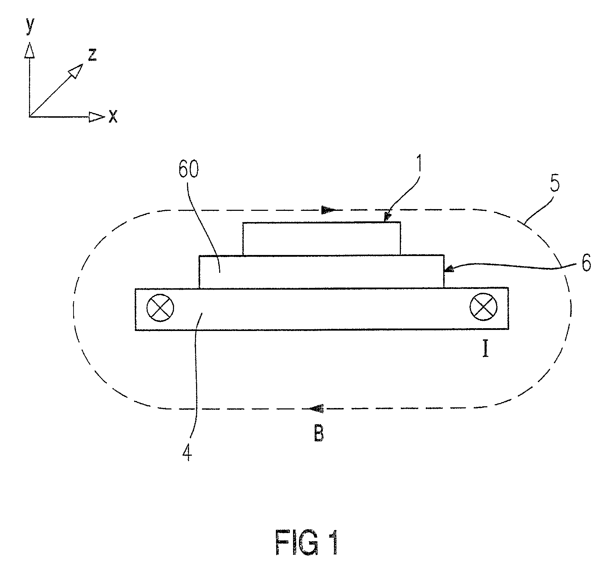

Figur 1 illustriert schematisch einen Aufbau zur Magnetfeld- bzw. Strommessung mittels einer in einem Halbleiterchip 1 integrierten Sensorvorrichtung. Ein in beispielsweise einer Stromschiene 4 fließender Strom in z-Richtung erzeugt das in Figur 1 gestrichelt dargestellte Magnetfeld B oberhalb der Oberfläche des Halbleiterchips 1 in x-Richtung. Mittels dieser Anordnung können bereits kleine Stromänderungen und daraus resultierend kleine Magnetfeldänderungen parallel zur Chipoberfläche mittels der Sensorvorrichtung detektiert werden.

Der Sensor ist vorzugsweise auf einer Platine 6 angebracht, auf der verschiedene Schaltungen bzw. Schaltungsblöcke 60 für eine Auswertung und Verarbeitung der Messsignale und Steuerung der entsprechenden Sensoren bzw. Elemente integriert sind.

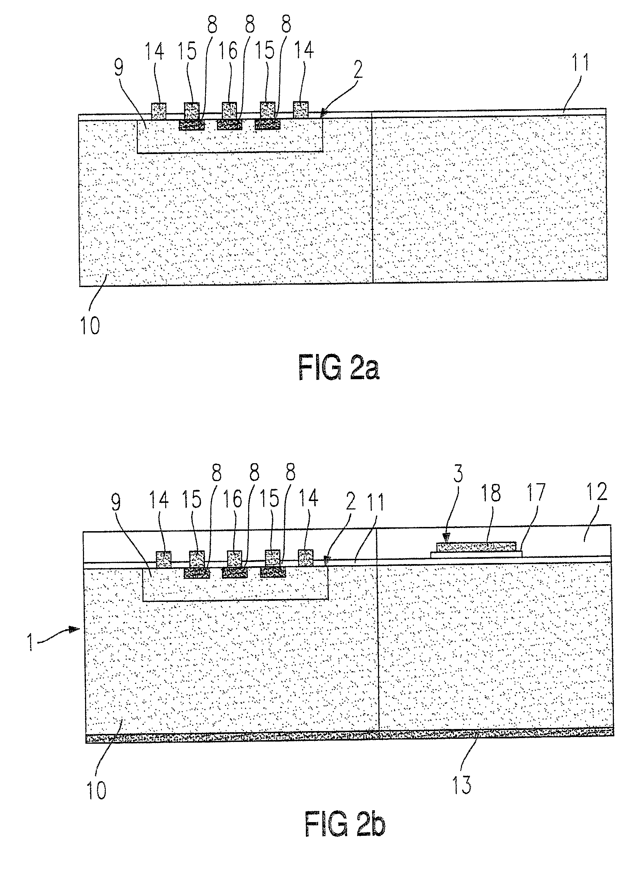

Die Figuren 2a und 2b zeigen einen Prozessablauf zur Herstellung einer Sensorvorrichtung gemäß einem ersten Ausführungsbeispiel der vorliegenden Erfindung.

Bei der in Figur 2b dargestellten Sensorvorrichtung gemäß dem ersten Ausführungsbeispiel handelt es sich um einen linearen Kombi-Magnetfeldsensor, wobei mindestens zwei lineare Sensorelemente 2,3 mit unterschiedlichen Messbereichen monolithisch in einem Halbleiterchip 1 integriert sind. Dieser lineare Kombi-Magnetfeldsensor weist zur Messung größerer Magnetfelder, beispielsweise ab einem Bereich von etwa 10 µT, ein Magnetotransistorelement 2, beispielsweise ein laterales Magnetotransistorelement (im folgenden mit LMT-Element bezeichnet), ein anderes Sensorelelement, das ein Magnetfeld parallel zur Si-Oberfläche messen kann, oder dergleichen auf.

Das LMT-Element 2 besteht beispielsweise aus einem bipolaren Transistor, hergerstellt mittels gängiger CMOS-Technologie. Das Signal ist die magnetfeldabhängige Stromdifferenz zweier Sensorkollektoren. Besondere Vorteile besitzt dieser Magnetfeldsensor in seiner guten Linearität, dem geringen Rauschen und der detektierten Feldrichtung. Der LMT-Sensor 2 kann Magnetfelder parallel zur Oberfläche des Halbleiterchips 1 messen.

Der LMT-Sensor 2 wird, wie in Figur 2a schematisch dargestellt, mit Hilfe eines Standard-Halbleiter-Prozesses, beispielsweise eines Silizium-Prozesses, auf einem n-dotierten Siliziumsubstrat 10 mit einem p-dotierten Siliziumbereich 9 hergestellt. Durch Metallisierungsverfahren werden die notwendigen Basisanschlüsse 14, Kollektoranschlüsse 15 und Emitteranschluss 16 des LMT-Elementes hergestellt.

Zusätzlich wird eine Isolationsschicht 11, beispielsweise eine einige µm dicke Siliziumoxid oder Siliziumdioxid-Schicht 11 auf der Substratoberfläche abgeschieden.

Anschließend wird in einem Postprozess ein magnetoresistives Sensorelement 3 derart auf der Isolationsschicht 11 hergestellt, dass das Magnetotransistorelement 2 und das magnetoresistive Sensorelement 3 bezüglich der Oberfläche des Halbleiterchips 1 nebeneinander monolithisch in dem Halbleiterchip 1 integriert sind.

Das magnetoresistive Sensorelement 3 ist insbesondere als AMR (Anisotropic Magneto Resistance)- oder GMR(Giant Magnetic Resistance)-Sensor 3 ausgebildet.

Bei einem AMR-Sensor hängt der Widerstand in einem stromdurchflossenen Streifen aus weichmagnetischem Material, beispielsweise NiFe (Permalloy), direkt vom Winkel zwischen dem fließenden Strom und der Magnetisierungsrichtung ab. Auch in diesem Fall liegt die Richtung des Magnetfeldes in der Schichtebene, das heißt es können Magnetfelder parallel zur Oberfläche des Halbleiterchips 1 gemessen werden.

Ein GMR-Sensor nutzt einen magnetoresistiven Effekt mit einer "gigantischen" Effektgröße, welcher in sehr dünnen Schichtsystemen, prinzipiell bestehend aus zwei magnetischen Schichten, zum Beispiel CO (Kobalt), und einer unmagnetischen Zwischenschicht, zum Beispiel Cu (Kupfer), und in daraus abgeleiteten Mehrschichtsystemen auftritt. Die Dicke der unmagnetischen Zwischenschichten ist vorzugsweise hierbei deutlich geringer als die mittlere freie Weglänge eines Elektrons. Der elektrische Widerstand längs der Schichtstruktur hängt hierbei direkt von der relativen Orientierung der magnetischen Momente der beiden Schichten ab. Somit können mit einem GMR-Sensor 3 ebenfalls Magnetfelder parallel zur Oberfläche des Halbleiterchips 1 gemessen werden.

Das magnetoresistive Sensorelement 3 besteht beispielsweise aus einer magnetoresistiven Schicht 17 und einer darüber vorgesehenen Metallschicht 18 und besitzt im Vergleich zu dem Magnetotransistorelement 2 einen unterschiedlichen Messbereich, da vorzugsweise Magnetfelder kleiner als 400µT mit einer zufriedenstellenden Genauigkeit messbar sind.

Anschließend werden in an sich bekannter Weise eine Passivierungsschicht 12 über die Sensorelemente 2, 3 bzw. über die Isolationsschicht 11 und eine Metallisierungsschicht 13 an der Rückseite des Siliziumchips 1 für ein elektrischen Anschluss erzeugt.

Das Magnetotransistorelement 2 weist in dem dargestellten Ausführungsbeispiel eine in npn-Struktur auf, bestehend aus einem n-dotierten Siliziumsubstrat 10, einem p-dotierten Siliziumbereich 9 und einem n-dotierten Silizium 8. Allerdings können die Magnetotransistorelemente 2 gleichermaßen eine pnp-Struktur aufweisen und/oder aus anderen entsprechend geeigneten Halbleitermaterialien bestehen.

Zur Auswertung der Messsignale des Magnetotransistorelemtes 2 und des magnetoresistiven Sensorelementes 3 kann beispielsweise eine Auswerteschaltung in dem Halbleiterchip 1 ebenfalls monolithisch integriert werden. Somit wird ein kompakter Aufbau der Anordnung mit kurzen Schaltstrecken erreicht.

Für eine Verarbeitung und Auswertung der Messsignale können auch verschiedene Schaltungsblöcke 60, beispielsweise auf einer unter dem Halbleiterchip 1 angeordneten Platine 6 (siehe Figur 1) vorgesehen sein, welche beispielsweise unterschiedliche Verstärkungsfaktoren besitzen. Somit kann mittels einer Software entsprechend einem auftretenden Signal bzw. einer auftretenden Magnetfeldgröße das entsprechend besser geeignete Sensorelement und der entsprechend dem Sensorelement zugeordnete Schaltungsblock aktiviert werden.

Es kann alternativ auch ein Schaltungsblock mit einstellbaren Eigenschaften, beispielsweise einstellbaren Verstärkungsfaktoren verwendet werden, wobei in diesem Fall mittels der Software entsprechend der auftretenden Magnetfeldgröße der Verstärkungsfaktor des Schaltungsblocks eingestellt und bestimmt wird, welche Signale von welchem Sensorelement relevant sind und entsprechend weiterverarbeitet werden.

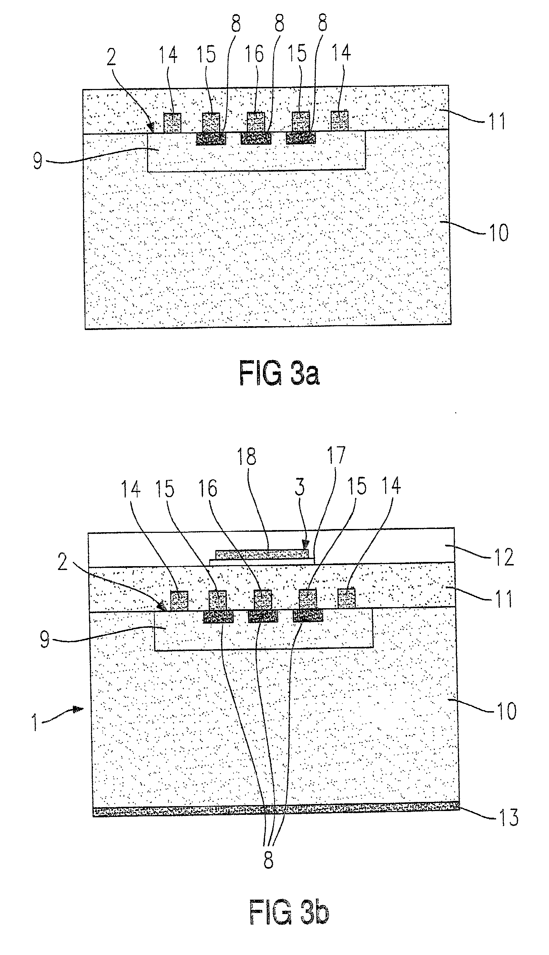

Die Figuren 3a und 3b illustrieren einen Prozessablauf zur Herstellung einer Sensorvorrichtung gemäß einem zweiten Ausführungsbeispiel der vorliegenden Erfindung.

Gemäß dem zweiten Ausführungsbeispiel der vorliegenden Erfindung werden die beiden Sensorelemente 2 und 3 bezüglich der Oberfläche des Halbleiterchips 2 monolithisch übereinander in dem Halbleiterchip 1 integriert. Dazu wird, wie in Figur 3a ersichtlich, die Isolationsschicht 11 nach Herstellung des Magnetotransistorelementes 2 über diesem und der Substratoberfläche derart gebildet, dass die Anschlüsse 14, 15 und 16 des Magnetotransistorelementes 2 vollständig von der Isolationsschicht 11 eben bedeckt sind.

In dem hier nachfolgenden Postprozess wird auf die Isolationsschicht 11 oberhalb des Magnetotransistorelementes 2 das magnetoresistive Sensorelement 3 aufgebracht.

Anschließend erfolgt in an sich bekannter Weise die Herstellung einer Passivierung 12 auf der Oberseite und einer Metallisierung 13 an der Unterseite der Sensorvorrichtung.

Nicht erläuterte Komponenten und Funktionsweisen entsprechen denen des ersten Ausführungsbeispiels gemäß Figuren 2a und 2b und bedürfen daher keiner weiteren Erläuterung.

Somit schafft die vorliegende Erfindung einen linearen Kombi-Magnetfeldsensor, der aus mindestens zwei linearen Sensorelementen 2 und 3 mit unterschiedlichen Messbereichen besteht, welche monolithisch in dem selben Halbleiterchip 1 integriert sind. Dadurch entsteht ein kostengünstigerer, kompakter und mit einem geringen Aufwand herstellbarer Sensor, mit dem Magnetfelder parallel zur Sensoroberfläche über einen breiten Messbereich detektiert und ausgewertet werden können.

Obwohl die vorliegende Erfindung anhand bevorzugter Ausführungsbeispiele vorstehend beschrieben wurde, ist sie darauf nicht beschränkt, sondern auf vielfältige Weise modifizierbar.

Insbesondere sind die angegebenen Materialien und Schichtdicken lediglich beispielhaft zu verstehen und es ist selbstverständlich, dass andere entsprechend geeignete Materialien verwendet werden können.

Ebenfalls können verschiedene und insbesondere mehr als zwei Sensorelemente verwendet werden, die sich monolithisch in den selben Halbleiterchip integrieren lassen und insgesamt einen ausreichend breiten Messbereich abdecken

### BEZUGSZEICHENLISTE

| | |
|---|---|
| 1 | Halbleiterchip |
| 2 | LMT - Element |
| 3 | magnetoresistives Sensorelement |
| 4 | Stromschiene |
| 5 | Magnetfeld |
| 6 | Platine |
| 8 | Si (n-dotiert) |
| 9 | Si (p-dotiert) |
| 10 | Halbleitersubstrat (n-dotiert) |
| 11 | Isolationsschicht |
| 12 | Passivierung |
| 13 | Metallisierung |
| 14 | Basisanschluss |
| 15 | Kollektoranschluss |
| 16 | Emitteranschluss |
| 17 | magnetoresistive Schicht |
| 18 | Metallschicht |
| 60 | Schaltungsblöcke |

## Patentansprüche

1. Sensorvorrichtung zur Messung von Magnetfeldern insbesondere über einen breiten Messbereich, mit:
einem Halbleiterchip (1);
mindestens einem Magnetotransistorelement (2); und mit mindestens einem magnetoresistiven Sensorelement (3);
wobei das Magnetotransistorelement (2) sowie das magnetoresistive Sensorelement (3) zur Messung von Magnetfeldern parallel zur Oberfläche des Halbleiterchips (1) monolithisch in dem Halbleiterchip (1) integriert sind.

2. Sensorvorrichtung nach Anspruch 1, **dadurch gekennzeichnet, dass** der Halbleiterchip (1) aus Silizium gebildet ist.

3. Sensorvorrichtung nach einem der Ansprüche 1 oder 2, **dadurch gekennzeichnet, dass** das Magnetotransistorelement (2) als lateraler Magnetotransistor, als anderes Sensorelelement, das ein Magnetfeld parallel zur Si-Oberfläche messen kann, oder dergleichen ausgebildet ist.

4. Sensorvorrichtung nach wenigstens einem der vorangehenden Ansprüche, **dadurch gekennzeichnet, dass** das magnetoresistive Sensorelement (3) als AMR(Anisotropic Magneto Resitance)-Element ausgebildet ist.

5. Sensorvorrichtung nach wenigstens einem der Ansprüche 1 bis 3, **dadurch gekennzeichnet, dass** das magnetoresistive Sensorelement (3) als GMR(Giant Magnetic Resistance)-Element ausgebildet ist.

6. Sensorvorrichtung nach wenigstens einem der vorangehenden Ansprüche, **dadurch gekennzeichnet, dass** das Magnetotransistorelement (2) und das magnetoresistive Sensorelement (3) bezüglich der Oberfläche des Halbleiterchips (1) nebeneinander in dem Halbleiterchip (1) monolithisch integriert sind.

7. Sensorvorrichtung nach wenigstens einem der Ansprüche 1 bis 5, **dadurch gekennzeichnet, dass** das Magnetotransistorelement (2) bezüglich der Oberfläche des Halbleiterchips (1) unter dem magnetoresistiven Sensorelement (3) in dem Halbleiterchip (1) monolithisch integriert ist.

8. Sensorvorrichtung nach wenigstens einem der vorangehenden Ansprüche, **dadurch gekennzeichnet, dass** eine Auswerteschaltung zum Auswerten der Messsignale des Magnetotransistorelementes (2) und des magnetoresistiven Sensorelementes (3) in dem Halbleiterchip (1) monolithisch integriert ist.

9. Sensorvorrichtung nach wenigstens einem der vorangehenden Ansprüche, **dadurch gekennzeichnet, dass** mehrere Schaltungsblöcke (60) mit unterschiedlichen Eigenschaften, beispielsweise unterschiedlichen Verstärkungsfaktoren, zur Verarbeitung und Auswertung der Messsignale mit den entsprechenden Elementen (2, 3) verbindbar sind, wobei für eine bestimmte Messung die entsprechenden Schaltungsblöcke (60) und Elemente (2,3) mittels einer Software entsprechend ansteuerbar sind.

10. Sensorvorrichtung nach wenigstens einem der Ansprüche 1 bis 8, **dadurch gekennzeichnet, dass** ein Schaltungsblock (60) mit steuerbaren Eigenschaften, beispielsweise einem steuerbaren Verstärkungsfaktor, mit den entsprechenden Elementen (2, 3) verbindbar ist, wobei der Schaltungsblock (60) für eine bestimmte Messung mittels einer Software entsprechend ansteuerbar ist.

11. Sensorvorrichtung nach wenigstens einem der vorangehenden Ansprüche, **dadurch gekennzeichnet, dass** das Magnetotransistorelement (2) eine npn- oder pnp-Struktur aufweist.

12. Verfahren zur Herstellung einer Sensorvorrichtung zur Messung von Magnetfeldern, insbesondere über einen breiten Messbereich, mit folgenden Schritten:
Bilden eines Magnetotransistorelementes (2) mittels eines Halbleiterprozesses in einem Halbleitersubstrat (10);
Bilden einer Isolationsschicht (11) auf der Oberfläche des Halbleitersubstrates (10); und
monolithisches Bilden eines magnetoresistiven Sensorelementes (3) auf der Isolationsschicht (11).

13. Verfahren nach Anspruch 12, **dadurch gekennzeichnet, dass** das Magnetotransistorelement (2) und das magnetoresistive Sensorelement (3) bezüglich der Oberfläche des Halbleitersubstrats (10) nebeneinander monolithisch hergestellt werden.

14. Verfahren nach Anspruch 12, **dadurch gekennzeichnet, dass** das Magnetotransistorelement (2) bezüglich der Oberfläche der Sensorvorrichtung unter dem magnetoresistiven Sensorelement (3) monolithisch hergestellt wird.

15. Verfahren nach wenigstens einem der Ansprüche 12 bis 14, **dadurch gekennzeichnet, dass** anschließend eine Passivierungsschicht (12) auf der Isolationsschicht (11) gebildet wird.

16. Verfahren nach wenigstens einem der Ansprüche 12 bis 15, **dadurch gekennzeichnet, dass** eine Metallisierungsschicht (13) auf der Unterseite des Halbleitersubstrates (10) gebildet wird.

17. Verfahren nach wenigstens einem der Ansprüche 12 bis 16, **dadurch gekennzeichnet, dass** mehrere Schaltungsblöcke (60) mit unterschiedlichen Eigenschaften, beispielsweise unterschiedlichen Verstärkungsfaktoren, zur Verarbeitung und Auswertung der Messsignale mit den entsprechenden Elementen (2, 3) verbunden werden, wobei für eine bestimmte Messung die entsprechenden Schaltungsblöcke (60) und Elemente (2, 3) mittels einer Software entsprechend angesteuert werden.

18. Verfahren nach wenigstens einem der Ansprüche 12 bis 16, **dadurch gekennzeichnet, dass** ein Schaltungsblock (60) mit steuerbaren Eigenschaften, beispielsweise einem steuerbaren Verstärkungsfaktor, mit den entsprechenden Elementen (2, 3) verbunden wird, wobei der Schaltungsblock (60) für eine bestimmte Messung mittels einer Software entsprechend angesteuert wird.
